# EUROPEAN PATENT APPLICATION

(11) **EP 4 651 202 A1**
(43) Date of publication of application: **19.11.2025**
(21) Application number: 24176446.3
(22) Date of filing: 16.05.2024
(51) Int. Cl.: H01L 23/31, H01L 23/66, H01L 23/28, H01L 23/29, H01L 23/552, H01L 23/498, H01L 23/36

(54) **RADIO FREQUENCY SEMICONDUCTOR DEVICE AND METHOD FOR FABRICATING A RADIO FREQUENCY SEMICONDUCTOR DEVICE**

(71) Applicant: Infineon Technologies AG, 85579 Neubiberg (DE)
(72) Inventor: KORNPROBST, Simon, 83071 Stephanskirchen (DE); ERDÖL, Tuncay, 82008 Unterhaching (DE); FURQAN, Muhammad, 4040 Linz (AT); HARTNER, Walter, 93077 Bad Abbach (DE); WOJNOWSKI, Maciej, 81735 München (DE)
(74) Representative: Infineon Patent Department

(57) **Abstract**

A radio frequency (RF) semiconductor device and a method to manufacture the RF semiconductor device. The RF semiconductor device comprises a semiconductor die comprising a first surface and sidewalls vertical to the first surface. A mold compound encapsulates the sidewalls of the semiconductor die, wherein the mold compound extends beyond sidewalls of the semiconductor die in a first direction vertical to sidewalls of the semiconductor die. The RF semiconductor device further comprises an RF absorption layer arrangement comprising a first RF absorption layer and a second RF absorption layer. The first RF absorption layer and the second RF absorption layer extend above the first surface of the semiconductor die in the first direction. The RF absorption layer arrangement comprises a first side facing towards the semiconductor die.

## Description

### TECHNICAL FIELD

The present disclosure relates to a radio frequency semiconductor device and in particular to a radio frequency semiconductor device with RF absorption layers with different dielectric properties. In addition, the present disclosure relates to method of manufacturing such devices.

### BACKGROUND

In radio frequency (RF) semiconductor devices, e.g. radar systems and radar sensors, an elimination of an undesired radiation or signal is a crucial factor for reliable device performance. For example, in the area of advanced driver assistant systems (ADAS), RF semiconductor devices play a crucial role and must be reliable and robust in performance and competitive in cost. To improve the performance and functionality of the RF semiconductor devices, more and more functions are packed into RF semiconductor devices with small packages or multi-die RF devices are introduced which leads to a higher interfering RF signal coupling between different RF transmission channels of the RF semiconductor device.

Mold compounds applied in the RF semiconductor device packaging usually exhibit low-loss properties such that the RF signal can propagate without significant attenuation. RF signals encounter reflection inside the RF semiconductor device and may couple the RF channels. This may cause poor performance or in some cases failure of the RF semiconductor device.

Accordingly, it is an object of the present application to provide a concept for an RF semiconductor device in which the absorption of RF signals is improved. This object is solved by a radio frequency semiconductor device according to claim 1 and a method of fabricating a radio frequency semiconductor device according to claim 21.

### SUMMARY

According to an example of the disclosure, a radio frequency (RF) semiconductor device to process RF signals in an operating frequency range is disclosed. The RF semiconductor device comprises a semiconductor die comprising a first surface and sidewalls vertical to the first surface. A mold compound encapsulates the sidewalls of the semiconductor die, wherein the mold compound extends beyond sidewalls of the semiconductor die in a first direction vertical to sidewalls of the semiconductor die. The RF semiconductor device further comprises an RF absorption layer arrangement comprising a first RF absorption layer and a second RF absorption layer. The first RF absorption layer and the second RF absorption layer extend above the first surface of the semiconductor die in the first direction. The RF absorption layer arrangement comprises a first side facing towards the semiconductor die. The first RF absorption layer extends on the first side within a first area and the second RF absorption layer extends on the first side within a second area. The first RF absorption layer has a first value of a real-part of a dielectric constant and the second RF absorption layer has a second value of a real-part of a dielectric constant, wherein the first value is different than the second value.

According to an example of the disclosure, a method for manufacturing a radio frequency (RF) semiconductor device to process RF signals in an operating frequency range is disclosed. The method comprises:
- providing a semiconductor die comprising a first surface and sidewalls vertical to the first surface;
- encapsulating the sidewalls of the semiconductor die by a mold compound, wherein the mold compound extends beyond sidewalls of the semiconductor die in a first direction vertical to sidewalls of the semiconductor die,
- disposing an RF absorption layer arrangement comprising a first RF absorption layer and a second RF absorption layer, the first RF absorption layer and the second RF absorption layer extending above the first surface of the semiconductor die in the first direction,

wherein the RF absorption layer arrangement comprises a first side facing towards the semiconductor die, wherein the first RF absorption layer extends on the first side within a first area and the second RF absorption layer extends on the first side within a second area, and
wherein the first RF absorption layer has a first value of a real-part of a dielectric constant and the second RF absorption layer has a second value of the real-part of the dielectric constant, wherein the first value is different than the second value.

### BRIEF DESCRIPTION OF THE DRAWINGS

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.
Fig. 1A illustrates a schematic cross-sectional view of an RF semiconductor device along a line AA of Figure 1B with an RF absorption layer arrangement arranged over a semiconductor die.
Fig. 1B illustrates a top view of the RF semiconductor device of Figure 1A without a mold compound.
Fig. 2 illustrates a cross-sectional view of an RF semiconductor device with an RF absorption layer arrangement arranged over a semiconductor die and a heat sink arranged over the RF absorption layer arrangement.
Figure 3 illustrates a schematic cross-sectional view of an RF semiconductor device, wherein a mold compound encapsulates sidewalls of a semiconductor die.
Figure 4 illustrates a schematic cross-sectional view of an RF semiconductor die mounted on a substrate.
Figure 5 illustrates an experimental result of a channel to channel isolation measurement of an RF semiconductor device with various RF absorption layers.
Figure 6 illustrates a flowchart of a method of manufacturing an RF semiconductor device comprising an RF absorption layer arrangement with different real-parts of dielectric constants.

### DETAILED DESCRIPTION

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

It should be noted that the description and drawings merely illustrate the principles of the proposed methods and systems. Those skilled in the art will be able to implement various arrangements that, although not explicitly described or shown herein, embody the principles of the invention and are included within its spirit and scope. Furthermore, all examples and embodiments outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

Embodiments described herein provide a new concept for absorbing RF signals in an RF semiconductor device comprising a semiconductor die. The new concept is based on the findings that an improved RF absorption characteristic and better RF channel isolation can be obtained if the properties of RF absorption layers provided in the RF semiconductor device are chosen and matched to address the various coupling and scattering scenarios in the RF semiconductor device. In RF semiconductor devices, output signal lines of RF transmission channels are typically positioned in the surrounding of the semiconductor die to transfer the RF signals to ports, launchers, antennas etc. In such signal lines, a portion of the transmitted RF signal may leak out of a respective signal line and these RF signals may be scattered inside the RF semiconductor device back to another signal line effecting a coupling of RF signals between such signal lines. Such couplings may lead to problems regarding qualification of the RF semiconductor device under ETSI (European Telecommunications Standards Institute) and FCC (Federal Communications Commission) regulations.

The concept proposed herein addresses the coupling between signal lines by taking into account that differences in the effectiveness of specific absorption layers and their position exist depending on the geometrical location of the signal lines (e.g. distance between the signal lines). For example, for signal lines that are close (for example signal lines that are positioned along a same sidewall of the semiconductor die), the RF signals causing the coupling are scattered with a small angle of scattering inside the RF semiconductor device. Whereas for signal lines having a larger distance (for example signals lines that are positioned at different sides of the semiconductor die), the RF signals causing the coupling are scattered with a large angle of scattering inside the RF semiconductor device. For example, RF signals are then transferred over the semiconductor die causing the coupling of the RF transmission channels positioned along the different sidewalls of the semiconductor die. This unwanted coupling of the RF transmission channels may introduce noise in the RF semiconductor device during operation.

To address this, an RF absorption layer arrangement comprising a first RF absorption layer and a second RF absorption layer is arranged over the first surface of the semiconductor die and both RF absorption layers extend in a first direction lateral to sidewalls of the semiconductor die. The RF absorption layers have a different value of a real-part of a dielectric constant from each other which allow absorption of RF signals for a wide range of angle of scattering inside the RF semiconductor device as will be described in more detail below. In view of this, overall improvement of channel to channel isolation in the RF semiconductor device is achieved.

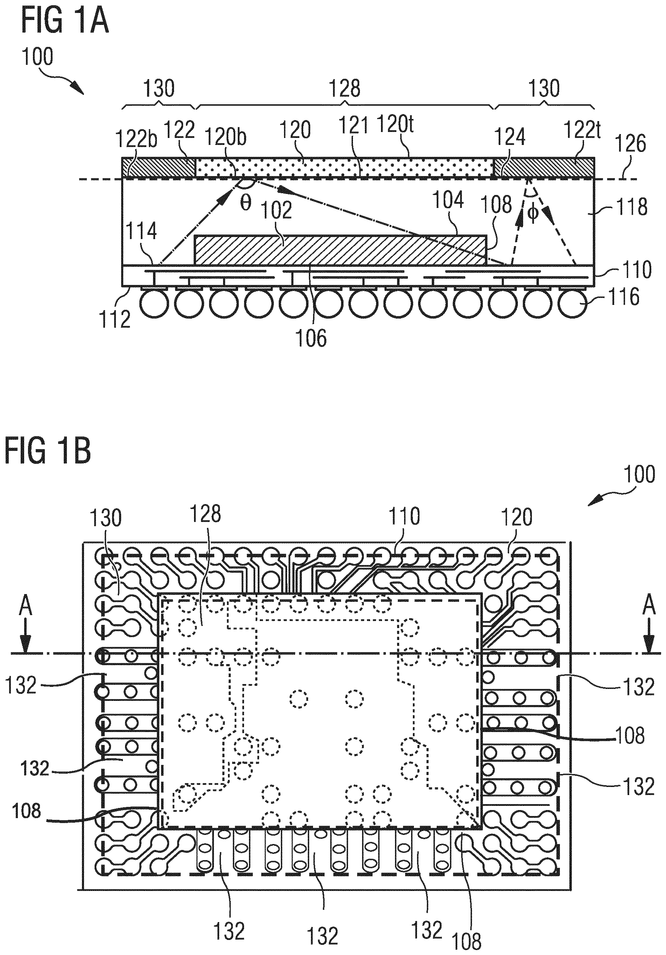

Figure 1A and Figure 1B illustrate a cross-sectional view and a top view of the RF semiconductor device 100 respectively. The cross-sectional view of Figure 1A is along the line AA of Figure 1B. For simplicity a mold compound 118 is not shown in the Figure 1B.

The semiconductor die 102 operates in a predetermined frequency range such as a millimeter-wave frequency range, for example in a frequency range that is contained in the range from 40 GHz to 500 GHz or in a frequency range that is contained in the range from 50 GHz to 250 GHz. In some examples, the semiconductor die 102 may correspond to a radar die and may be used as a transmitter, a receiver, a sensor, a detector etc. In other examples the semiconductor die 102 may be a 5G or 6G communication die, a high data transfer communication system, wireless backhaul systems of body scanning systems for security.

As shown in Figure 1A, the semiconductor die 102 has a first surface 104, a second surface 106 opposite to the first surface 104 and sidewalls 108 connecting the surfaces 104, 106 of the semiconductor die 102. The first surface 104 and the second surface 106 may be referred to as a first main surface and second main surface. An active die area having transistors and other circuit elements is provided in the semiconductor die 102. The active die area may be capable of generating RF signals, processing RF signals, and analyzing RF signals and other signals.

The second surface 106 of the semiconductor die 102 is arranged on a top side 114 of a redistribution layer 110 and an electrical contact is established between the semiconductor die 102 and electrically conductive structures of the redistribution layer 110. For example, the electrical contact may be formed by a bond pad which may be made of aluminum and/or copper. This allows an RF signal to be transmitted from the semiconductor die 102 to the electrical contacts and/or vice-versa.

The redistribution layer 110 may comprise one or more laminated layers and may have one or more electrically conductive structures in form of metal lines or metal planes, running parallel to the first surface 104 of the semiconductor die 102. The electrically conductive structures route electric signals in the RF semiconductor device 100. The electrically conductive structures may be made of aluminum, copper or a copper alloy. In some examples, the electrically conductive structures may be electrically isolated from each other by a dielectric material. The dielectric material in the redistribution layer may for example comprise an organic material such as polymer material.

The redistribution layer 110 has a bottom side 112 opposite to the top side 114. A plurality of solder balls 116 is arranged on the bottom side 112 of the redistribution layer 110. Accordingly, the redistribution layer 110 establishes the electrical connection between the solder balls 116 and the semiconductor die 102. A printed circuit board (PCB) (which is not shown in Figure 1) may be electrically and mechanically mounted to the solder balls 116. The solder balls 116 may comprise according to one example at least one of Sn, Ag, or Cu. The solder balls 116 may have diameters in a range between 200 and 400 µm and pitches in a range between of 400 and 600 µm. In some examples, Flip-Chip BGAs (Ball Grid Arrays) or Wirebond-BGA may be used for establishing the electrical and mechanical connection to the PCB.

The redistribution layer 110 may extend beyond the second surface 106 of the semiconductor die 102 in a first direction, wherein the first direction is vertical to the sidewalls 108 of the semiconductor die 102. In other words, the redistribution layer 110 extends in a lateral direction beyond the semiconductor die 102. A part of the redistribution layer 110 which extends beyond the second surface 106 of the semiconductor die 102 forms a fan-out area. The fan-out area has signal lines of RF transmission channels which are configured to transmit and receive RF signals in the RF semiconductor device.

The semiconductor die 102 is partially encapsulated by a mold compound 118. In particular, the first surface 104 and sidewalls 108 of the semiconductor die 102 are encapsulated by the mold compound 118 while the second surface 106 of the semiconductor die 102 is exposed from the mold compound 118. The mold compound 118 further extends beyond the sidewalls 108 of the semiconductor die 102 in the first direction and is in contact with the fan-out area of the redistribution layer 110. A part of the redistribution layer 110 which faces the second surface 106 of the semiconductor die 102 is exposed from the mold compound 118. A first side 124 of the mold compound 118 faces the first surface 104 of the semiconductor die 102.

A top view of the RF semiconductor device 100 shown in Figure 1B, is a view from an outside of the RF semiconductor device 100 and in a direction orthogonal to the first surface 104 of the semiconductor die 102 (in a vertical direction). As described herein, the RF signals leaking out of the signal lines may scatter inside the RF semiconductor device 100 which leads to a coupling of the RF transmission channels 132. The scattering of the RF signal may take place for example at the first side 124 of the mold compound 118 as shown in Figure 1A or the first surface 104 of the semiconductor die 102. The RF transmission channels 132 located along the different sidewalls 108 of the semiconductor die 102 may be coupled by RF signals scattered with an angle (*θ*) which is above a first value of a scattering angle and the RF transmission channels 132 located along the same sidewall 108 of the semiconductor die 102 may be coupled by RF signals which are scattered with another angle (*ϕ*) having a value below the first value of the scattering angle. According to one example, the first value of scattering angle may be in a range of 30° -50°.

In order to absorb the RF signals with various angles (*θ*,*ϕ*), an RF absorption layer arrangement a first RF absorption layer 120 and a second RF absorption layer 122 are arranged over the first surface 104 of the semiconductor die 102 as shown in Figure 1A and 1B. The first RF absorption layer 120 and the second RF absorption layer 122 form an RF absorption layer arrangement. The first RF absorption layer 120 has a first value of a real-part of a dielectric constant (the real part is sometimes also referred to as the real part of the relative permittivity or Dk) and the second RF absorption layer 122 has a second value of the real-part of the dielectric constant, wherein the first value of the real-part of the dielectric constant is different than the second value of the real-part of the dielectric constant. In one example, the first value of the real-part of the dielectric constant is greater than the second value of the real-part of the dielectric constant. For example, the first value of the real-part of the dielectric constant may be greater than or equal to 11 and wherein the second value of the real-part of the dielectric constant may be less than 11. The first RF absorption layer 120 is provided for absorbing the RF signals scattered with the angle (*θ*) i.e., above the first value of scattering angle, whereas the second RF absorption layer is provided for absorbing the RF signals scattered with the angle (*ϕ*) i.e., below the first value of scattering angle.

As shown in Figures 1A-1B, the RF absorption layer arrangement has an inner side 121 facing towards the semiconductor die 102. The first RF absorption layer 120 extends on the inner side 121 only within a first area 128 and the second RF absorption layer 122 extends on the inner side 121 outside of the first area 128. The area outside of the first area 128 may be referred as a second area 130. The first area 128 and the second area 130 extend in the first direction (lateral direction).

The inner side 121 is co-planer i.e, the inner side 121 is aligned to a plane 126 parallel to the first direction. In some examples, the inner side 121 may not be co-planer i.e., different parts of the inner side 121 may be aligned to different planes parallel to each other.

The first area 128 comprising the first RF absorption layer 120 may overlap with the first surface 104 of the semiconductor die 102. The first area 128 may completely overlap with the first surface 104 of the semiconductor die 102 in which case an overlap area between the first area 128 and the first surface 104 of the semiconductor die 102 is identical to the first area 128. The first area 128 may in some examples partially overlap with the first surface 104 in which case the overlap area is smaller than the first area 128. Furthermore, the second area 130 comprising the second RF absorption layer 122 may completely or partially overlap with the fan-out area of the redistribution layer 110. In some examples, the first area 128 may be larger than the first surface 104 of the semiconductor die 102. while in other examples the first area128 may be smaller than the first surface 104 of the semiconductor die 102. The first area 128 covers where the RF signals are scattered above the first value of scattering angle and the second area 130 covers where the RF signals are scattered below the first value of scattering angle.

As shown in Figure 1A and Figure 1B, the first RF absorption layer 120 is arranged in this example within the first area 128 in a continuous manner such that the first RF absorption layer 120 is confined within the first area 128. The second RF absorption layer 122 is arranged within the second area 130 in a continuous manner such that the second RF absorption layer 122 is confined within the second area 130 only. In other words, the second RF absorption layer 130 is completely excluded from the first area 128.

In Figure 1A, the areas 128, 130 comprising the respective RF absorption layer 120, 122 are arranged on the first side 124 of the mold compound 118. The side of the RF absorption layer arrangement facing the semiconductor die 102 may be in direct contact with the mold compound 118. A bottom surface 120b, 122b of the respective RF absorption layer 120, 122 faces the first side 124 of the mold compound 118. The bottom surface 120b of the first RF absorption layer 120 further faces the first surface 104 of the semiconductor die 102. Both RF absorption layers 120, 122 are arranged adjacent to each other (for example in direct contact to each other) and may form a contiguous inhomogeneous layer. The bottom surface 120b, 122b of each RF absorption layer 120, 122 may be aligned with respect to the plane 126 parallel to the first direction. However, the bottom surface 120b, 122b of each RF absorption layer 120, 122 may be aligned to different planes parallel to the first direction. In other words, the contiguous inhomogeneous layer may have inhomogeneity in regards of dielectric properties and a height of the respective RF absorption layer (as explained below).

The first RF absorption layer 120 may have a first height measured between the bottom surface 120b and an opposing top surface 120t of the first RF absorption layer 120 in a direction vertical to the first direction. Similarly, the second RF absorption layer 122 may have a second height measured between the bottom surface 122b and an opposing top surface 122t of the second RF absorption 122 in the direction vertical to the first direction. The first height may be the same as or different to the second height. In other words, the thickness of the first RF absorption layer 120 may be the same or different to the thickness of the second RF absorption layer 122. In one example, the first RF absorption layer 120 and the second RF absorption layer 122 may have a thickness in a range from 50 µm to 2 mm or 100 µm to 1 mm or 100 µm to 2mm.

The first and second RF absorption layers 120 and 122 may comprise an RF absorbing material including at least one of elastomer material, rubber material, silicone, polyurethane. In some embodiments, specific absorbing particles may be incorporated in the first and the second RF absorption layers 120 and 122 e.g., AlOx, SiOx, Si, SiC, TiOx, FeOx, FeZn, ZnOx, MnOx, wherein x is either 1 or 2. Different materials may be used for the first and second RF absorption layers 120 and 122 or a different density of absorbing particles may be used to obtain the different values for the dielectric perm ittivity.

In some examples, the first RF absorption layer 120 has a loss tangent greater than 0.2, whereas the second RF absorption layer 122 may have a loss tangent which is the same or different than the loss tangent of the first RF absorption layer 120. The loss tangent of the first and the second RF absorption layers 120, 122 in aforementioned ranges is suitable for dissipation of RF signals absorbed in the respective RF absorption layers 120, 122.

As shown in Figure 1B, the fan-out area or the signal lines of the RF transmission channels are positioned along the sidewalls 108 of the semiconductor die 102, therefore the first area 128 is aligned with the first surface 104 of the semiconductor die 102. Accordingly, the first RF absorption layer 120 completely overlaps with the first surface 104 of the semiconductor die 102. The first RF absorption layer 120 absorbs the RF signal scattered with the angle (*θ*)which is above the first value of scattering angle and hence improves the channel to channel isolation between the RF transmission channels positioned along the different sidewalls 108 of the semiconductor die 102. Similarly, the second RF absorption layer 120 absorbs the RF signal scattered with the angle (*ϕ*) which is below the first value of scattering angle and improves the channel to channel isolation between the RF transmission channels positioned along the same sidewall 108 of the semiconductor die 102.

The mold compound 118 may have Dk value in a range 3 to 5 which is also below the second value of the Dk of the second RF absorption layer 122. By having the Dk of mold compound and the Dk of the second RF absorption layer in the same range, the scattering of the RF signal at the interface between the mold compound 118 and the second RF absorption layer 122 is almost negligible and the RF signal is transmitted to the second absorption layer 122 even for the small scattering angle. Hence, the channel to channel isolation of the RF transmission channels positioned along the same sidewall 108 of the semiconductor die 102 is further improved.

It is to be noted that the RF absorption layers 120, 122 may form a part of a semiconductor package comprising the semiconductor device 100. Alternatively, the RF absorption layers 120, 122 may be arranged external to a semiconductor package comprising the semiconductor device 100 for example as a layer on the mold compound 118.

In order to dissipate the heat from the RF semiconductor device, a heat sink in form of metal may be mounted to the RF semiconductor device. Without the RF absorption layers 120 and 122, the RF signals emitted from the RF semiconductor device may be transferred to the heat sink and the heat sink may provide a perfect scatterer thereby increasing the coupling between the signal lines.

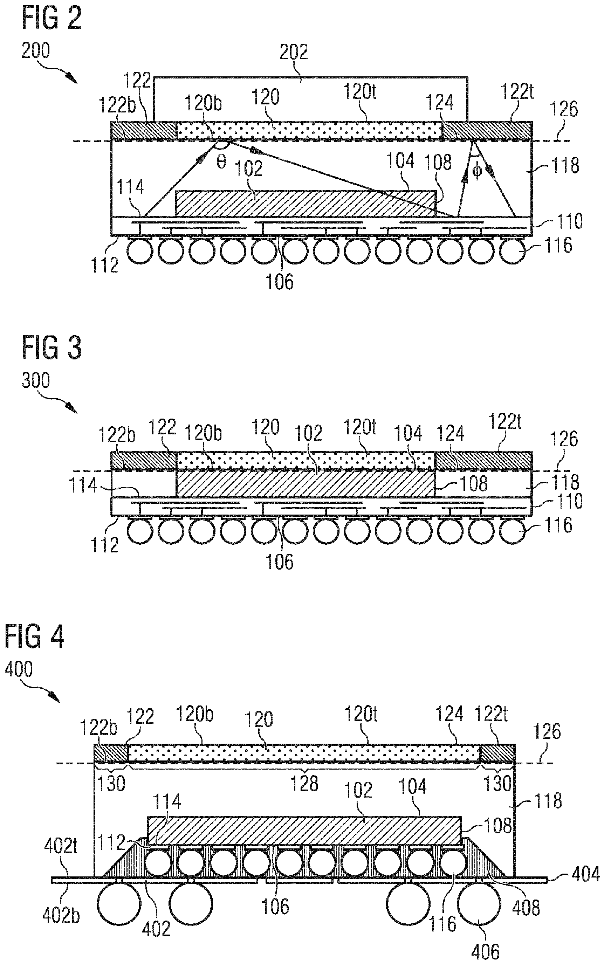

Figure 2 shows a cross-sectional view of an RF semiconductor device 200 which comprises the RF semiconductor device 100 of Figure 1A with a heat sink 202. The heat sink 202 is arranged over the top surfaces 120t, 122t of the RF absorption layers 120, 122. Due to the RF absorption layers 120, 122, the transfer of RF signals between the semiconductor device 100 and the heat sink 202 may be significantly reduced. Additionally, both RF absorption layers 120, 122 may have a heat conductivity above 0.5 W/mK or 1.0 W/mK or 1.5 W/mK which makes the RF absorption layers 120, 122 further suitable for transferring the heat from the RF semiconductor device 100 to the heat sink 202. In order to have no or reduced scattering from the heat sink 202, the loss tangent of the RF absorption layer 120, 122 may be high e.g., greater than equal to 0.2. By arranging the RF absorption layers 120, 122 between the RF semiconductor device 100 and the heat sink 202, the transfer of RF signals scattered at the heat sink 202 back to the RF semiconductor device may be reduced and further the RF absorption layers 120, 122 may increase the heat dissipation of the RF semiconductor device 200 during operation.

Figure 3 shows a cross-sectional view of an RF semiconductor device 300 according to a further example. The RF semiconductor device 300 may include some or all features of the RF semiconductor device of Figure 2. For the sake of simplicity, the heat sink is omitted. The new concept may be extended to the RF semiconductor device 300 where the first surface 104 and the second surface 106 of the semiconductor die 102 are both exposed from the mold compound 118. In other words, the mold compound 118 encapsulates only the sidewalls 108 of the semiconductor die 102. The first RF absorption layer 120 is arranged on the first surface 104 of the semiconductor die 102. In other examples, the first RF absorption layer 120 may extend to a part of the first side 124 of the mold compound in the first direction. The second RF absorption layer 122 is arranged on the first side 124 of the mold compound 118.

Figure 4 shows an example of an RF semiconductor device 400, which may include some or all features of any of the RF semiconductor device 100, 200 and 300 of Figures 1A, 1B, 2 and 3.

In the RF semiconductor device 400, the second surface 106 of the semiconductor die 102 is mounted on the solder balls 116 instead of the redistribution layer. The solder balls 116 are confined within the second surface 106 of the semiconductor die 102 and soldered to a top 402t of a substrate 402, e.g. an intermediate board integrated in the package of the semiconductor device 400. The substrate 402 comprises a routing structure 404 facing the second surface 106 of the semiconductor die 102. Further solder balls 406 are arranged on the bottom 402b of the substrate 402. An underfill material 408 is arranged between the top 402t of the substrate 402 and the semiconductor die 102. In particular, the underfill material 408 fully covers each of solder balls 116 and partially covers the sidewalls 108 of the semiconductor die 102 and parts of the substrate 402. The mold compound 118 encapsulates a part of the substrate 402 and an outer peripheral of the underfill material 408. The underfill material 1008 may be a material such as a thermoset epoxy which reduces thermal stress occurring due to a mismatch of a coefficient of thermal expansion between the substrate 402 and the semiconductor die 102.

The RF signals from the semiconductor die 102 are routed between the solder balls 116 and the solder balls 406 via the routing structure 404 of the substrate 402. The signal lines of the RF transmission channels are formed on the substrate 402 which may be positioned away from the semiconductor die 102. To address this, the first RF absorption layer 120 may extend in the lateral direction beyond the first surface 104 of the semiconductor die 102 and further overlaps with the signal lines of the RF transmission channels of the substrate 402.

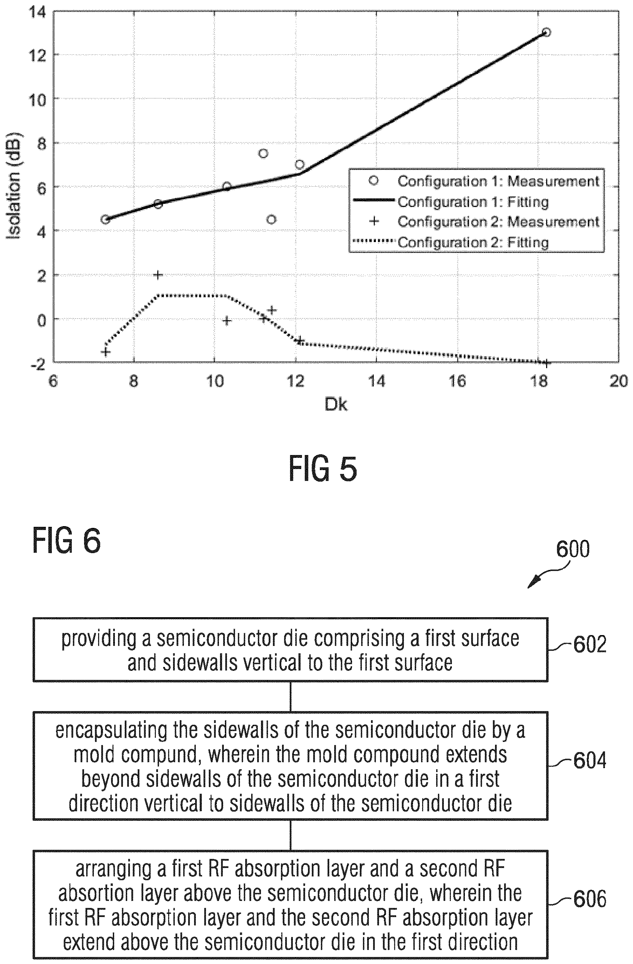

In order to determine an appropriate selection of materials and Dk values for the first and second RF absorption layers 120, 122, measurements for various Dk values have been performed. Figure 5 shows a channel to channel isolation measurement performed with the RF semiconductor device 200 of Figure 2. In the measurements, the solder balls 116 of the RF semiconductor device 200 have been electrically and mechanically coupled with a printed circuit board. Instead of the first RF absorption layer 120 and the second RF absorption layer 122, an RF absorption layer is arranged between the first side 124 of the mold compound 118 and the heat sink 202. The channel to channel isolation measurement is performed for two different configurations of RF transmission channels namely configuration 1 and configuration 2 as a function of Dk of the RF absorption layers at a frequency of 77 GHz. The difference between the configuration 1 and configuration 2 is explained later.

In Figure 5, the y-axis (ordinate) shows an isolation value in dB for the respective configuration which is normalized with respect to the corresponding measurements on another RF semiconductor device without the RF absorption layer. The x-axis (abscissa) shows the Dk value of the RF absorption layer extracted from the bulk material characterization.

The circles in the Figure 5 correspond to channel to channel isolation measurement for the configuration 1 and the straight line is a corresponding fit. The configuration 1 comprises a pair of RF transmission channels, wherein one of the RF transmission channels in the pair of RF transmission channels is positioned along the adjacent or opposing sidewall of the semiconductor die 102 with respect to the other RF transmission channel in the pair of the RF transmission channels. For example, one of the RF transmission channels in the pair of RF transmission channels may be a transmit channel and other RF transmission channel in the pair of RF transmission channel may be a receive channel.

As the RF transmission channels in the configuration 1 are positioned along different sidewalls 108 of the semiconductor die 102, the angle of scattering between the RF transmission channels of the configuration 1 is above the first value of scattering angles i.e., greater than or equal to 50°. With increasing value of the Dk of the RF absorption layer, the channel to channel isolation between the RF transmission channels of the configuration 1 improves and also shows no dependence on the loss tangent value of the RF absorption layer as long as the loss tangent of the RF absorption layer is greater than 0.2.

The crosses (+) in Figure 5 show a channel to channel isolation measurement performed on a configuration 2 which comprises a pair of transmit channels or a pair of receive channels separately. The dotted line is a corresponding fit. Both transmit/receive channels in the configuration 2 are positioned along the same sidewall of the semiconductor die 102.

It can be seen that there is a significant difference in the channel to channel isolation values for RF transmission channels of the configuration 2 as compared to the configuration 1 which is attributed to the shorter distance between the signal lines of each pair of RF transmission channels in the respective configurations. As the signal lines of the RF transmission channels in the configuration 2 are positioned along the same sidewall of the semiconductor die 102, the angle of scattering between the RF transmission channels of the configuration 2 is below the first value of scattering angle i.e. less than 50°. In this case, the loss tangent of the RF absorption layer is also crucial for absorption of RF signals. For the RF transmission channels of the configuration 2, below Dk =8 of the RF absorption layer, the poor isolation between the RF transmission channels of the configuration 2 is due to small value of the loss tangent which is around 0.2. With increasing Dk of the RF absorption layers, the loss tangent of the RF absorption layers also increases which improves the channel to channel isolation between the RF transmission channels of the configuration 2.

It is to be noted that the channel to channel isolation for the RF transmission channels of the configuration 2 improves up to Dk = 11 and on further increasing the Dk of the RF absorption layer the channel to channel isolation gets worse even though the loss tangent increases. This is due to reason that the DK of the RF absorption layer below 11 is suitable for RF signals scattering below the first value of scattering angle and as the Dk of the RF absorption layer increases above 11, the RF signals are scattered back into the RF semiconductor device.

Figure 6 illustrates a method for manufacturing a radio frequency (RF) semiconductor device to process RF signals in an operating frequency range. In a step 602 a semiconductor die is provided which comprises a first surface and sidewalls vertical to the first surface. In a further step 604, the sidewalls of the semiconductor die are encapsulated by a mold compound, wherein the mold compound extends beyond sidewalls of the semiconductor die in a first direction vertical to sidewalls of the semiconductor die. In a further step 606, an RF absorption layer arrangement is disposed above the first surface of the semiconductor die. The RF absorption layer arrangement has a first RF absorption layer, a second RF absorption layer and an inner side. The first RF absorption layer and the second RF absorption layer extend above the first surface of the semiconductor die in the first direction. The inner side faces the first surface of the semiconductor die. The first RF absorption layer extends on the first side within a first area and the second RF absorption layer extends on the first side within a second area. The first RF absorption layer has a first value of a real-part of dielectric constant and the second RF absorption layer has a second value of a real-part of dielectric constant, wherein the first value is different than the second value.

In the step 606, the first RF absorption layer and the second RF absorption layer may be arranged within the first area and the second area respectively by e.g., jetting, jet printing, laser cutting or a combination of them.

In the step 606, the second RF absorption layer is arranged within the second area in the top view and the first area is left empty. In a further step, the first RF absorption layer is arranged within the first area.

Alternatively in the step 606, the second RF absorption layer may be arranged within the first and the second areas and followed by removing the second RF absorption layer within the first area e.g., by laser. The first RF absorption layer is arranged within the first area.

In some examples, the step 606 may form a part of manufacturing of semiconductor package comprising the semiconductor device. Alternatively, the RF absorption layers may be pre-manufactured and then arranged external to a semiconductor package comprising the semiconductor device.

The new concept provides an effective and cost-efficient RF signal absorption arrangement in the RF semiconductor devices. As described herein, the first RF absorption layer overlaps with the semiconductor die and the RF second RF absorption layer with smaller Dk than the first RF absorption layer is arranged outside of the first RF absorption layer. Such arrangement of RF absorption layer increases the absorption of RF signals with various scattering angles and hence improving the channel to channel isolation of RF transmission channels of the RF semiconductor device. Further, a heat sink may be attached above the RF absorption layers using standard thermal interface materials for cooling purposes. The values of the real-part of the dielectric constant may be fine-tuned according to an operating frequency of the RF semiconductor device. The RF absorption layers absorb and dissipate the RF signals generated within the RF semiconductor device as well as from external sources which may increase the performance of the RF semiconductor device and may reduce damages to the semiconductor die.

The following examples pertain to further aspects of the disclosure:
Example 1 discloses a radio frequency (RF) semiconductor device to process RF signals in an operating frequency range comprising:
   - a semiconductor die comprising a first surface and sidewalls vertical to the first surface,
   - a mold compound encapsulating the sidewalls of the semiconductor die, wherein the mold compound extends beyond the sidewalls of the semiconductor die in a first direction vertical to the sidewalls of the semiconductor die,
   - an RF absorption layer arrangement comprising a first RF absorption layer and a second RF absorption layer, the first RF absorption layer and the second RF absorption layer extending above the first surface of the semiconductor die in the first direction,

   wherein the RF absorption layer arrangement comprises a first side facing towards the semiconductor die, wherein the first RF absorption layer extends on the first side within a first area and the second RF absorption layer extends on the first side within a second area, and
   wherein the first RF absorption layer has a first value of a real-part of a dielectric constant and the second RF absorption layer has a second value of a real-part of a dielectric constant, wherein the first value is different than the second value.
Example 2 discloses the semiconductor device according to example 1, wherein the first value of the real-part of the dielectric constant is greater than the second value of the real-part of the dielectric constant.
Example 3 discloses the semiconductor device according to example 2, wherein the first value of the real-part of the dielectric constant is greater than or equal to 11 and wherein the second value of the real-part of the dielectric constant is less than 11.
Example 4 discloses the RF semiconductor device according to example 3, wherein in the top view the first area overlaps with the first surface of the semiconductor die.
Example 5 discloses the RF semiconductor device according to example 4, wherein in the top view the first area is completely within the first surface of the semiconductor die.
Example 6 discloses the RF semiconductor device according to any preceding examples, wherein in the top view the second RF absorption layer is completely outside the first area.
Example 7 discloses the RF semiconductor device according to any preceding examples, wherein the first RF absorption layer and the second RF absorption layer are adjacent to each other in the top view.
Example 8 discloses the RF semiconductor device according to any preceding examples, wherein the first RF absorption layer and the second RF absorption layer form a contiguous layer over the first surface of the semiconductor die.
Example 9 discloses the semiconductor device according to any preceding examples, wherein the mold compound further encapsulates the first surface of the semiconductor die, wherein a first side of the mold compound faces the first surface of the semiconductor die, wherein the first RF absorption layer is arranged over the first side of the mold compound and wherein the second RF absorption layer is arranged over the first side of the mold compound.
Example 10 discloses the semiconductor device according to any preceding examples, wherein the first RF absorption layer has a height in a same range as a height of the second RF absorption layer, wherein the height of each RF absorption layer is measured between a bottom surface and an opposing respective top surface of the respective RF absorption layer in a direction vertical to the first direction and wherein the bottom surface of each RF absorption layer faces the first surface of the semiconductor die .
Example 11 discloses the RF semiconductor device according to any preceding examples, wherein the first RF absorption layer and the second RF absorption layer form a part of an outer portion of a semiconductor package of the semiconductor device.
Example 12 discloses the RF semiconductor device according to any of the preceding examples, wherein the mold compound has a real-part of a dielectric constant in a range of 3-5.
Example 13 discloses the RF semiconductor device according to any of the preceding examples, wherein the first RF absorption layer has a loss tangent greater than 0.2.
Example 14 discloses the RF semiconductor device according to example 13, the second RF absorption layer has a loss tangent less than 0.2.
Example 15 discloses the RF semiconductor device according to example 13, the second RF absorption layer has a loss tangent greater than or equal to 0.2.
Example 16 discloses the RF semiconductor device according to any preceding examples, wherein a heat sink is arranged above the first RF absorption layer and the second RF absorption layer.
Example 17 discloses the RF semiconductor device according to any of the preceding examples, wherein the first RF absorption layer and the second RF absorption layer comprises at least one of the filler material e.g., AlOx, SiOx, Si, SiC, TiOx, FeOx, FeZn, ZnOx, MnOx, wherein x is either 1 or 2.
Example 18 discloses the RF semiconductor device according to any preceding examples, wherein the RF semiconductor device comprises a redistribution layer facing a second surface of the semiconductor die opposite to the first surface,
   wherein a part of the redistribution layer extends beyond the second surface of the semiconductor die in the first direction, and
   wherein the second RF absorption layer at least partially faces the part of the redistribution layer extending beyond the second surface of the semiconductor die.
Example 19 discloses the RF semiconductor device according to example 18, wherein the part of the redistribution layer extending beyond the second surface of the semiconductor die comprises an RF transmission channel.
Example 20 discloses the RF semiconductor device according to any preceding example, wherein the first RF absorption layer has a thermal conductivity above 0.5 W/mK and the second RF absorption layer has a thermal conductivity above 0.5 W/mK.
Example 21 discloses a method for manufacturing a radio frequency (RF) semiconductor device to process RF signals in an operating frequency range comprising:
   - providing a semiconductor die comprising a first surface and sidewalls vertical to the first surface;
   - encapsulating the sidewalls of the semiconductor die by a mold compound, wherein the mold compound extends beyond the sidewalls of the semiconductor die in a first direction vertical to the sidewalls of the semiconductor die,
   - disposing an RF absorption layer arrangement comprising a first RF absorption layer and a second RF absorption layer, the first RF absorption layer and the second RF absorption layer extending above the first surface of the semiconductor die in the first direction,
      wherein the RF absorption layer arrangement comprises a first side facing towards the semiconductor die, wherein the first RF absorption layer extends on the first side within a first area and the second RF absorption layer extends on the first side within a second area, and
      wherein the first RF absorption layer has a first value of a real-part of a dielectric constant and the second RF absorption layer has a second value of the real-part of the dielectric constant, wherein the first value is different than the second value.

## Claims

1. A radio frequency (RF) semiconductor device (100, 200, 300, 400) to process RF signals in an operating frequency range comprising:
- a semiconductor die (102) comprising a first surface (104) and sidewalls (108) vertical to the first surface (104);
- a mold compound (118) encapsulating the sidewalls (108) of the semiconductor die (102), wherein the mold compound (118) extends beyond the sidewalls (108) of the semiconductor die (102) in a first direction vertical to the sidewalls (108) of the semiconductor die (102),
- an RF absorption layer arrangement comprising a first RF absorption layer (120) and a second RF absorption layer (122), the first RF absorption layer (120) and the second RF absorption layer (122) extending above the first surface (104) of the semiconductor die (102) in the first direction,
wherein the RF absorption layer arrangement comprises a first side (121) facing towards the semiconductor die (102), wherein the first RF absorption layer (120) extends on the first side within a first area (128) and the second RF absorption layer (122) extends on the first side within a second area (130), and
wherein the first RF absorption layer (120) has a first value of a real-part of a dielectric constant and the second RF absorption layer (122) has a second value of the real-part of the dielectric constant, wherein the first value is different than the second value.

2. The semiconductor device (100, 200, 300, 400) according to claim 1, wherein the first value of the real-part of the dielectric constant is greater than the second value of the real-part of the dielectric constant.

3. The semiconductor device (100, 200, 300, 400) according to claim 2, wherein the first value of the real-part of the dielectric constant is greater than or equal to 11 and wherein the second value of the real-part of the dielectric constant is less than 11.

4. The RF semiconductor device (100, 200, 300, 400) according to claim 3, wherein in the top view the first area (128) overlaps with the first surface (104) of the semiconductor die (102).

5. The RF semiconductor device (100, 200, 300) according to claim 4, wherein in the top view the first area (128) is completely within the first surface (104) of the semiconductor die (102).

6. The RF semiconductor device (100, 200, 300, 400) according to any preceding claims, wherein in the top view the second RF absorption layer (122) is completely outside the first area (128).

7. The RF semiconductor device (100, 200, 300, 400) according to any preceding claims, wherein the first RF absorption layer (120) and the second RF absorption layer (122) are adjacent to each other in the top view.

8. The RF semiconductor device (100, 200, 300, 400) according to any preceding claims, wherein the first RF absorption layer (120) and the second RF absorption layer (122) form a contiguous layer over the first surface (104) of the semiconductor die (102).

9. The semiconductor device (100, 200, 400) according to any preceding claims, wherein the mold compound (118) further encapsulates the first surface (104) of the semiconductor die (102), wherein a first side (126) of the mold compound (118) faces the first surface (104) of the semiconductor die (102), wherein the first RF absorption layer (120) is arranged over the first side (126) of the mold compound (118) and wherein the second RF absorption layer (122) is arranged over the first side (126) of the mold compound (118).

10. The semiconductor device (100, 200, 300, 400) according to any preceding claims, wherein the first RF absorption layer (120) has a height in a same range as a height of the second RF absorption layer (122), wherein the height of each RF absorption layer (120, 122) is measured between a bottom surface (120b, 122b) and an opposing respective top surface (120t, 122t) of the respective RF absorption layer (120, 122) in a direction vertical to the first direction and wherein the bottom surface (120b, 122b) of each RF absorption layer (120, 122) faces the first surface (104) of the semiconductor die (102).

11. The RF semiconductor device (100, 200, 300, 400) according to any preceding claims, wherein the first RF absorption layer (120) and the second RF absorption layer (122) form a part of an outer portion of a semiconductor package of the semiconductor device (100, 200, 300, 400).

12. The RF semiconductor device (100, 200, 300, 400) according to any of the preceding claims, wherein the mold compound (118) has the real-part of the dielectric constant in a range of 3-5.

13. The RF semiconductor device (100, 200, 300, 400) according to any of the preceding claims, wherein the first RF absorption layer (120) has a loss tangent greater than 0.2.

14. The RF semiconductor device (100, 200, 300, 400) according to claim 13, the second RF absorption layer (122) has a loss tangent less than 0.2.

15. The RF semiconductor device (100, 200, 300, 400) according to claim 13, the second RF absorption layer (122) has a loss tangent greater than or equal to 0.2.

16. The RF semiconductor device (200) according to any preceding claims, wherein a heat sink (202) is arranged above the first RF absorption layer (120) and the second RF absorption layer (122).

17. The RF semiconductor device (100, 200, 300, 400) according to any of the preceding claims, wherein the first RF absorption layer (120) and the second RF absorption layer (122) comprises at least one of the filler material e.g., AlOx, SiOx, Si, SiC, TiOx, FeOx, FeZn, ZnOx, MnOx, wherein x is either 1 or 2.

18. The RF semiconductor device (100, 200, 300, 400) according to any preceding claims, wherein the RF semiconductor device comprises a redistribution layer (110, 404) facing a second surface (106) of the semiconductor die (102) opposite to the first surface (104),
wherein a part of the redistribution layer (110, 404) extends beyond the second surface (106) of the semiconductor die (102) in the first direction, and
wherein the second RF absorption layer (122) at least partially faces the part of the redistribution layer (110, 404) extending beyond the second surface (106) of the semiconductor die (102).

19. The RF semiconductor device (100, 200, 300, 400) according to claim 18, wherein the part of the redistribution layer (110, 410) extending beyond the second surface (106) of the semiconductor die (102) comprises an RF transmission channel (132).

20. The RF semiconductor device (100, 200, 300, 400) according to any preceding claim, wherein the first RF absorption layer (120) has a thermal conductivity above 0.5 W/mK and the second RF absorption layer (122) has a thermal conductivity above 0.5 W/mK.

21. A method for manufacturing a radio frequency (RF) semiconductor device (100, 200, 300, 400) to process RF signals in an operating frequency range comprising:
- providing a semiconductor die (102) comprising a first surface (104) and sidewalls (108) vertical to the first surface (104);
- encapsulating the sidewalls (108) of the semiconductor die (102) by a mold compound (118), wherein the mold compound (118) extends beyond the sidewalls (108) of the semiconductor die (102) in a first direction vertical to the sidewalls (108) of the semiconductor die (102),
- disposing an RF absorption layer arrangement comprising a first RF absorption layer (120) and a second RF absorption layer (122), the first RF absorption layer (120) and the second RF absorption layer (122) extending above the first surface (104) of the semiconductor die (102) in the first direction,
wherein the RF absorption layer arrangement comprises a first side (121) facing towards the semiconductor die (102), wherein the first RF absorption layer (120) extends on the first side within a first area (128) and the second RF absorption layer (122) extends on the first side within a second area (130), and
wherein the first RF absorption layer (120) has a first value of a real-part of a dielectric constant and the second RF absorption layer (122) has a second value of the real-part of the dielectric constant, wherein the first value is different than the second value.
